# EUROPÄISCHE PATENTSCHRIFT

(11) **EP 0 464 230 B1**
(45) Veröffentlichungstag und Bekanntmachung des Hinweises auf die Patenterteilung: **18.09.1996**
(21) Anmeldenummer: 90112531.0
(22) Anmeldetag: 30.06.1990
(51) Int. Cl.: H03L 7/099, H04N 9/87

(54) **Digitale Phasenregelungsschleife**
Digital phase locked loop
Boucle d'asservissement de phase numérique

(43) Veröffentlichungstag der Anmeldung: 08.01.1992
(73) Patentinhaber: Deutsche ITT Industries GmbH, D-79108 Freiburg (DE)
(72) Erfinder: Désor, Hans-Jürgen, Dipl.-Ing., D-7803 Gundelfingen 2 (DE); Flamm, Peter, Dipl.-Ing., D-7806 March-Buchheim (DE); Winterer, Martin, Dipl.-Phys., D-7803 Gundelfingen (DE)

(56) Entgegenhaltungen:
- EP-A- 0 062 541
- EP-A- 0 239 412
- EP-A- 0 239 413
- US-A- 4 330 791
- US-A- 4 689 664

## Beschreibung

Die Erfindung betrifft eine digitale Phasenregelungsschleife, mit einem periodisch überlaufenden Digitaloszillator, der ein die Periodendauer T aufweisendes Digitaloszillator-Ausgangssignal erzeugt, indem ein Registerwort der Wortlänge N sukzessive im vorgegebenen Takt eines Taktgenerators um ein an einem Eingang des Digitaloszillators anliegendes Steuerwort inkrementiert wird, und mit einer Prozessoreinrichtung, welcher das die Ist-Phase des Digitaloszillators repräsentierende Digitaloszillator-Ausgangssignal zugeleitet wird, und die zum Abgleich der Periodendauer T des Digitaloszillators auf eine durch periodisch auftretende Synchronisierimpulse festgelegte Nominal-Periodendauer einen Phasenvergleich zwischen der Ist-Phase des Digitaloszillators und einer vorgegebenen Soll-Phase durchführt, derart, daß die Prozessoreinrichtung in einem durch die periodisch auftretenden Synchronisierimpulse vorgegebenen ersten Regeltakt aus der momentanen Ist-Phase des Digitaloszillators und aus der Soll-Phase ein Phasendifferenzsignal bildet, und daß das Phasendifferenzsignal in einer Schleifenfiltereinheit der Prozessoreinrichtung gefiltert wird, und daß das gefilterte Phasendifferenzsignal zu einem Frequenzwort addiert wird, das den Zahlenwert der Nominal-Periodendauer in Abhängigkeit von der Wortlänge N des Registerwortes des Digitaloszillators und des vorgegebenen Taktes des Taktgenerators derart repräsentiert, daß der Digitaloszillator bei einem sukzessiven Akkumulieren des Registerwortes um das Frequenzwort in der Nominal-Periodendauer überläuft, und daß das aus dem Frequenzwort und dem Phasendifferenzsignal gebildete Steuerwort dem Eingang des Digitaloszillators zugeführt wird.

Eine derartige digitale Phasenregelungsschleife (DPLL=digital phase locked loop) ist z.B. aus EP-A 0 239 412, EP-A 0 239 413, EP-A 0 062 541, US 4 330 791 oder US 4 689 664 bekannt. Sie wird insbesondere in einer Horizontalablenkeinheit eines Fernsehempfängers zur Erzeugung der Horizontalablenkfrequenz verwendet. Zu diesem Zweck muß die Frequenz bzw. die Periodendauer des Digitaloszillators auf eine Nominalfrequenz bzw. Nominal-Periodendauer eingeregelt werden, welche durch die den Anfang einer jeden Zeile des Fernsehbildes kennzeichnenden, zeilenperiodisch auftretenden Synchronisierimpulse des Videosignals festgelegt wird. Diese zeilenperiodischen Synchronisierimpulse werden in einer der digitalen Phasenregelungsschleife vorgeschalteten Impulstrennstufe aus dem Luminanzsignal des Videosignals separiert und zu einem Komparator der Impulstrennstufe geleitet. Dieser triggert bei fallender Signalflanke der Synchronisierimpulse die Prozessoreinrichtung der digitalen Phasenregelungsschleife. Der Inhalt des Registerwortes des Digitaloszillators zu diesem Triggerzeitpunkt wird als die momentane Ist-Phase des Digitaloszillators abgespeichert. Der Phasenvergleich zwischen der momentanen Ist-Phase des Digitaloszillators und der vorgegebenen Soll-Phase zu diesem Zeitpunkt sowie die Nachführung der Periodendauer des Digitaloszillators erfolgt dann in der oben beschriebenen Art und Weise. Die Prozessoreinrichtung führt also den zur Einregelung der Periodendauer T des Digitaloszillators auf die Nominal-Periodendauer der zeilenperiodischen Synchronisierimpulse nötigen Abgleich in dem durch die zeitliche Abfolge der zeilenperiodischen Synchronisierimpulse festgelegten Regeltakt durch: Es erfolgt ein einziger Abgleich pro zeilenperiodischem Synchronisierimpuls (pro Zeile eines Fernsehbildes).

Die bekannten digitalen Phasenregelungsschleifen besitzen den Nachteil, daß sie nicht mehr stabil arbeiten, wenn die zeitliche Abfolge der zeilenperiodisch auftretenden Synchronisierimpulse durch weitere, nicht-zeilenperiodische Synchronisierimpulse unterbrochen wird, die gegenüber den zeilenperiodischen Synchronisierimpulsen um eine halbe Zeile- d.h. um 180° - versetzt auftreten. Diese Situation tritt durch die normgemäßen Vor- und Nachtrabenten bei der Wiedergabe jeder letzten Zeile eines ersten Halbbildes und jeder ersten Zeile eines zweiten Halbbildes eines im Zeilensprungverfahren übertragenen Fernsehbildes auf. Ebenso tritt ein halbzeiliger Versatz eines Synchronisierimpulses bei bestimmten Betriebsarten eines Videorecorders - z.B. beim Suchlauf - auf. Die nicht-zeilenperiodischen Synchronisierimpulse führen dazu, daß die Rastung des Digitaloszillators auf die Horizontalablenkfrequenz gestört wird, da bei den bekannten digitalen Phasenregelungsschleifen alle an diese gelangende Synchronisierimpulse - also auch die nicht-zeilenperiodischen - den Phasen-Abgleichvorgang auslösen. Die auf einen zeilenperiodischen Regeltakt ausgelegte Prozessoreinrichtung ist nicht in der Lage, die nicht-zeilenperiodischen von den zeilenperiodischen Synchronisierimpulsen zu unterscheiden und regelt in jedem Fall den Digitaloszillator nach. Dies beeinflußt in besonders nachteiliger Art und Weise die Stabilität der Rastung des Digitaloszillators auf die Nominal-Periodendauer, da die digitale Phasenregelungsschleife den Digitaloszillator nach jedem in die Phasenregelung eingehenden nicht-zeilenperiodischen Synchronisierimpuls neu auf die Nominal-Periodendauer einregeln muß.

Die nicht-zeilenperiodischen Synchronisierimpulse beeinflussen nicht nur die Horizontalablenkeinheit eines Fernsehempfängers. Vielmehr sind auch die zeilenfrequent ablaufenden Operationen des Videosignal-Processings betroffen, da die Phase des Digitaloszillators als Adressphase zur Steuerung des zeitlichen Ablaufs dieser Operationen herangezogen wird. Die einer bestimmten Operation des Videosignal-Processings zugeordnete Adressphase legt den Zeitpunkt fest, zu dem diese Operation innerhalb einer jeden Zeile des Fernsehbildes auszuführen ist. Um eine exakte Synchronisation dieser Zeitmarken mit dem Videosignal zu gewährleisten, wird die auf die zeilenperiodischen Synchronisierimpulse gerastete Phase des Digitaloszillators zur Adressierung dieser Operationen verwendet.

Ein nicht-zeilenperiodisch auftretender Synchronisierimpuls bedeutet aber, daß auch das darauffolgende Videosignal (Luminanzsignal und Chrominanzsignal) der betreffenden Zeile gegenüber der vorhergehenden Zeile um 180° versetzt auftritt. Eine korrekte Adressierung der zeilenfrequenten Operationen des Videosignal-Processings erfordert dann aber eine entsprechende Korrektur der Adressphase, d.h. diese muß um 180° gegenüber der Phase des Digitaloszillators verschoben werden.

Bei den bekannten Phasenregelungsschleifen tritt also die Problematik auf, daß einerseits die um 180° versetzt auftretenden, nicht-zeilenperiodischen Synchronisierimpulse die Phasen des Digitaloszillators nicht beeinflussen sollen, und daß andererseits die korrekte Adressierung der zeilenfrequenten Operationen des Videosignal-Processings erfordert, bei nicht-zeilenperiodischen Synchronisierimpulsen die als Adressphase dienende Phase des Digitaloszillators entsprechend zu korrigieren, um diese weiterhin als Adressphase verwenden zu können.

Zur Behebung dieser Problematik stellt sich die Erfindung die **Aufgabe,** eine digitale Phasenregelungsschleife der eingangs genannten Art derart weiterzubilden, daß sie auch bei nicht-zeilenperiodisch auftretenden Synchronisierimpulsen stabil arbeitet. Außerdem soll die erfindungsgemäße digitale Phasenregelungsschleife eine korrekte Adressierung der zeilenfrequenten Operationen des Videosignal-Processings über die Phase des Digitaloszillators ermöglichen.

Die Aufgabe wird erfindungsgemäß in einer Phasenregelungsschleife nach dem Oberbegriff des Anspruchs 1 dadurch gelöst, daß die Prozessoreinrichtung eine mit dem Digitaloszillator-Ausgangssignal verkoppelte Signalfolge der halben Zeilenperiodendauer erzeugt, deren Periodendauer TD gleich der halben Periodendauer T des Digitaloszillator-Ausgangssignals ist, und daß die 0 Prozessoreinrichtung nach dem Einrasten des Digitaloszillators auf die Nominal-Periodendauer den Phasenvergleich zwischen Ist-Phase und Soll-Phase in einem durch die zeilenperiodischen Synchronisierimpulse und einen nicht-zeilenperiodischen Synchronisierimpuls vorgegebenen zweiten Regeltakt anhand der Signalfolge der halben Zeilenperiodendauer durchführt, und daß das Digitaloszillator-Ausgangssignal einer Korrektureinrichtung zugeführt wird, die ein mit dem Digitaloszillator-Ausgangssignal verkoppeltes Adressphasensignal erzeugt, derart, daß die Adressphase des Adressphasensignals bei einem nicht-periodischen Synchronisierimpuls gegenüber der Phase des Digitaloszillator-Ausgangssignals um eine Periodendauer TD der Signalfolge der halben Zeilenperiodendauer verschoben wird.

Die erfindungsgemäße digitale Phasenregelungsschleife zeichnet sich dadurch aus, daß sie auch dann störungsfrei funktioniert, wenn die zeitliche Abfolge der periodisch auftretenden Synchronisierimpulse durch weitere, um eine halbe Periodendauer T gegenüber den (zeilen)periodischen Synchronisierimpulsen versetzte nicht-(zeilen)periodische Synchronisierimpulse unterbrochen wird. Der im zweiten Regeltakt durchgeführte Phasenvergleich bewirkt vorteilhafterweise nicht nur, daß die nicht-periodischen Synchronisierimpulse die digitale Phasenregelungsschleife nicht stören. Die erfindungsgemäßen Maßnahmen ermöglichen es vielmehr, die nicht-periodischen Synchronisierimpulse aktiv in den Phasenregelungsvorgang einzubeziehen, wodurch ein sehr schnelles Einschwingverhalten der erfindungsgemäßen digitalen Phasenregelungsschleife erreicht wird. Erfindungsgemäß ist nämlich vorgesehen, daß zwei Phasenvergleiche pro Nominal-Periodendauer (d.h. pro Zeile) gegebenen Falls durchgeführt werden. Die digitale Phasenregelungsschleife zeichnet sich außerdem durch einen über den vollen Winkelbereich von 360° linearen Zusammenhang zwischen Soll-Phase und Ist-Phase aus, da die Phasendifferenz zwischen diesen beiden Phasen linear über den gesamten, durch den Regeltakt vorgegebenen Zeitraum berechnet werden. Desweiteren ist es möglich, die erfindungsgemäße Phasenregelungsschleife zur Einregelung des Digitaloszillators auf fast beliebige Nominalfrequenzen zu verwenden. Die erfindungsgemäße Korrektureinrichtung der digitalen Phasenregelungsschleife erlaubt es in besonders vorteilhafter Art und Weise, ein mit der Phase des Digitaloszillators starr verkoppeltes Adressphasensignal zu erzeugen, das dann bei einem nicht-periodisch auftretenden Synchronisierimpulse dem versetzten Videosignal entsprechend angepaßt wird. Die Synchronität der zeilenfrequenten Operationen des Videosignal-Processings mit dem zugrundeliegenden Videosignal ist dadurch immer gewährleistet. Das erfindungsgemäß erzeugte Adressphasensignal erlaubt es daher, verschiedenste Operationen des Videosignal-Processings in beliebiger Phasenlage, d.h. zu einem beliebigen Zeitpunkt innerhalb jeder Zeile des Fernsehbildes durchzuführen. Dies ermöglicht auch eine vorteilhafte Horizontal-Synchronimpulsaufbereitung im Videorecorder, insbesondere bei der Trick-Wiedergabe wie Langsam-, Schnellauf-, Standbild- oder Rücklaufwiedergabe.

Vorteilhafte Weiterbildungen der Erfindung ergeben sich aus den Unteransprüchen.

Weitere Einzelheiten der Erfindung sind dem Ausführungsbeispiel zu entnehmen, das im folgenden anhand der Zeichnungen beschrieben wird. Es zeigen:
- Figur 1: ein Ausführungsbeispiel einer digitalen Phasenregelungsschleife,
- Figuren 2a-2e: die zeitliche Korrelation zwischen dem Luminanzsignal und den in der digitalen Phasenregelungsschleife auftretenden signalfolgen.

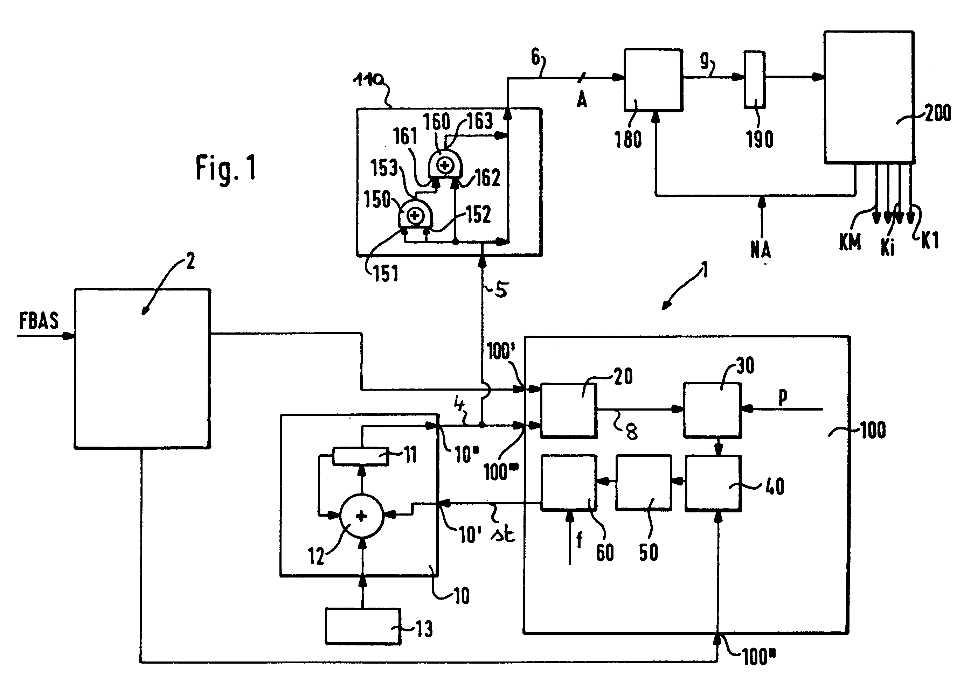

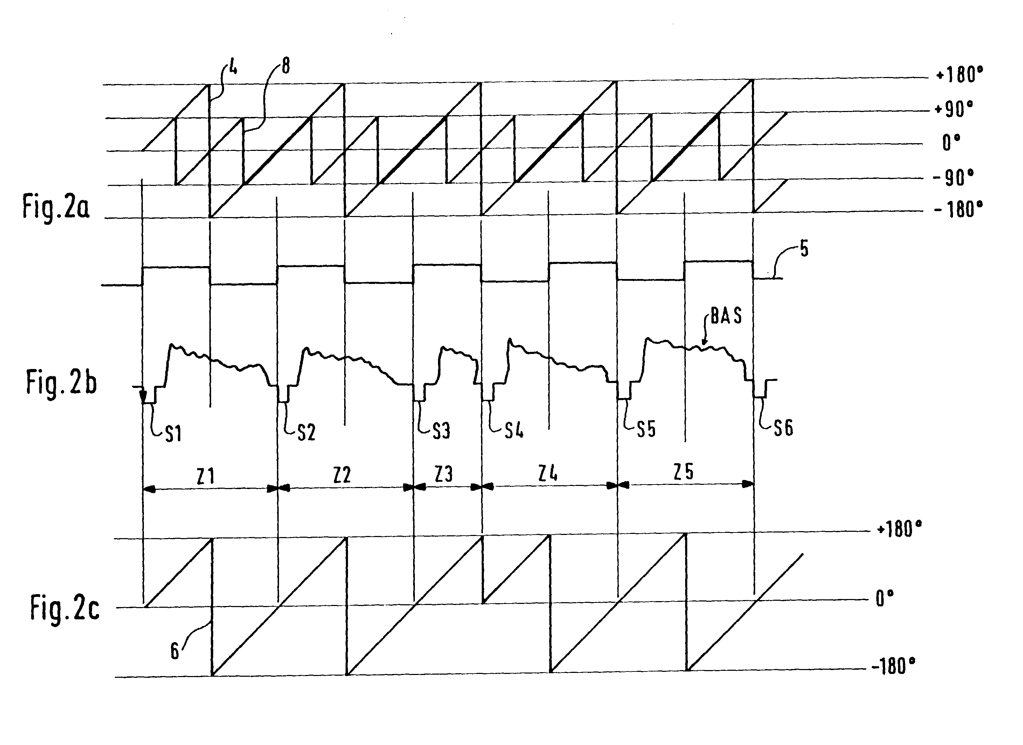

Der in Fig. 1 dargestellten, aus einem Digitaloszillator 10 und einer Prozessoreinrichtung 100 bestehenden digitalen Phasenregelungsschleife 1 ist eine Impulstrennstufe 2 vorgeschaltet, die zur Abtrennung und zur Aufbereitung der im Luminanzsignal BAS eines Videosignals FBAS (FBAS = Farb-Bild-Austast-Synchron-Signalgemisch) enthaltenen Synchronisierimpulse S1-S6 (vgl. dazu Fig. 2b) dient. Eine vergleichbare digitale Synchronisier abtrennstufe ist beispielsweise in EP-A 0 309 610 beschrieben. Der an sich bekannten und daher in Figur 1 nicht näher dargestellten Impulstrennstufe 2 wird das auf ca. 2 MHz begrenzte Luminanzsignal BAS zugeführt und mittels eines MTA-Tiefpaßfilters (MTA = Moving Time Averager) rauschbefreit. Ein Komparator der Impulstrennstufe 2 triggert bei fallender Signalflanke der Synchronisierimpulse S1-S6 ein Flip-Flop, dessen Ausgangssignal einem ersten Eingang 100' der Prozessoreinrichtung 100 der digitalen Phasenregelungsschleife 1 zugeführt wird. Die Impulstrennstufe 2 weist ferner einen Minimum-Meßwertspeicher auf, der das Synchronisations-Minimum des Luminanzsignals BAS festhält. Die Schwarzschulter des Luminanzsignals BAS wird getastet gemessen. Ein Mikroprozessor der Impulstrennstufe 2 berechnet aus diesen beiden Werten den Synchronisations-Abtrennpegel und den Stellwert der Schwarzwertregelung. Außerdem wird in der Umgebung des Abtrennzeitpunkts durch geeignete Verfahren (etwa lineare Interpolation oder oversampling) ein auf Taktbruchteile genauer Phasenwert berechnet (= skew data). Dieses Ausgangssignal des Mikroprozessors wird einem zweiten Eingang 100'' der Prozessoreinrichtung 100 zugeführt.

Die Separation der Synchronisierimpulse S1-S6 vom Luminanzsignal BAS und deren Aufbereitung und Aufspaltung in die Ausgangssignale des Flip-Flops und des Mikroprozessors bewirkt, daß die beiden an die Prozessoreinrichtung 100 geführten Ausgangssignale der Impulstrennstufe 2 eine unterschiedliche zeitliche Auflösung aufweisen: Das am Eingang 100' anliegende Ausgangssignal des Flip-Flops weist eine zeitliche Genauigkeit von einem Takt (clock) eines die Impulstrennstufe 2 und die digitale Phasenregelungsschleife 1 steuernden Taktgenerators 13 auf. Dieses Signal dient demgemäß zur Triggerung des Phasenabgleichs und zur Grobrastung des Digitaloszillators. Das im Mikroprozessor der Impulstrennstufe 2 aus der Flanke der Synchronisierimpulse des Luminanzsignals BAS berechnete digitale Ausgangssignal weist als Inhalt eine Phasenangabe mit einer Genauigkeit von Taktbruchteilen auf (Skew-Data) und wird zur Feinrastung der DPLL herangezogen. Da die Prozessoreinrichtung 100 die aus einem Synchronisierimpuls S1-S6 gewonnenen Ausgangssignale der Impulstrennstufe simultan und funktional unabhängig verarbeitet, wird im Verlauf der weiteren Beschreibung diese Unterscheidung nicht mehr durchgeführt. Es ist für einen Fachmann selbstverständlich, daß unter dem allgemeinen Begriff "Synchronisierimpuls" beide Ausgangssignale der Impulstrennstufe 2 verstanden werden.

Der Digitaloszillator (DCO) 10 der digitalen Phasenregelungsschleife 1 ist im Ausführungsbeispiel nach Fig. 1 als periodisch überlaufender Akkumulator (Modulo-Addierer) 10 aufgebaut. Ein derartiges Rechenwerk besteht aus einem Akkumulator-Register 11 und einem Addierer 12. Das Akkumulator-Register 11 speichert ein binäres Registerwort der Wortlänge N, dessen aktueller Wert als die duale Repräsentation einer Dezimalzahl in der Zweier-Komplement- oder in der Vorzeichen-Betrag-Darstellung (VBD) betrachtet wird: Das äußerst links stehende Bit des Registerwortes - das Bit N - wird zur Angabe des Vorzeichens und die restlichen Bits N-1, N-2, ..., 1 werden zur Darstellung des Betrags der binär im Akkumlator-Register 11 enthaltenen Dezimalzahl verwendet. Der Addierer 12 akkumuliert das Registerwort des Akkumulator-Registers 11 schrittweise im Takt des Taktgenerators 13 um ein am Eingang 10' des Akkumulators 10 anliegendes Steuerwort st. Bei der fortlaufenden Summation wird der Übertrag des Addierers 12 nicht berücksichtigt. Wird durch die sukzessive, taktweise Akkumulierung des Akkumulator-Registers 11 der maximale binäre Wertebereich des Registerwortes überschritten, so nimmt dieses wieder den Wert Null plus dem übergelaufenen (niederstelligen) Wert an: Demzufolge liegt an einem Ausgang 10'' des Digitaloszillators 10 ein Digitaloszillator-Ausgangssignal (DCO-Ausgangssignal) als Datensignal an, das - wie aus der das DCO-Ausgangssignal repräsentierenden Linie 4 der Figur 2a zu ersehen ist - zeitlich einen sägezahnförmigen Werteverlauf aufweist. Die sukzessive Akkumulierung des Registerwortes des Akkumulator-Registers 11 um das am Eingang 10' anliegende Steuerwort st bewirkt, daß der Wert des DCO-Ausgangssignals während der ersten Hälfte der Digitaloszillator-Periode T schrittweise vom Wert Null bis zum positiven Maximalwert des dezimalen Wertebereichs zunimmt, im ersten Takt der zweiten Hälfte der Digitaloszillator-Periode T vom dezimalen positiven Maximalwert zum dezimalen negativen Minimalwert des Wertbereiches springt und anschließend während der weiteren Takte der zweiten Hälfte der Digitaloszillator-Periode T schrittweise dem Anfangswert Null zustrebt. Dieses sägezahnförmige DCO-Ausgangssignal des Digitaloszillators 10 repräsentiert den Phasengang des Digitaloszillators, wobei jedem Wert des Registerwortes des Akkumulator-Registers 11 genau ein Phasenwert zugeordnet ist. Die Realisierung des Digitaloszillators 10 als periodisch überlaufender Akkumulator bewirkt in besonders vorteilhafter Art und Weise, daß eine lineare Zuordnung zwischen Amplitude des DCO-Ausgangssignals und Digitaloszillator-Phase über den vollen Winkelbereich von 360° erreicht wird.

Das DCO-Ausgangssignal wird an einen dritten Eingang 100''' der Prozessoreinrichtung 100 geführt, die nachfolgend genannte Funktionseinheiten aufweist. Dabei ist in besonders vorteilhafter Art und Weise vorgesehen, daß die in den einzelnen Funktionseinheiten auszuführenden Verarbeitungsoperationen des digitalen DCO-Ausgangssignales durch einen programmgesteuerten Mikrocomputer ausgeführt werden: Die o.g. Funktionseinheiten stellen also die einzelnen Abschnitte eines Flußdiagrammes eines entsprechenden Computerprogrammes dar.

Es ist aber auch möglich, die genannten Funktionseinheiten hardwaremäßig als fest verdrahtete Logikschaltung einer ntegrierten Schaltung oder als diskrete Bauelemente zu realisieren. Es liegt im Belieben eines Fachmannes, aus den genannten Alternativen die dem jeweiligen Einsatzzweck adäquateste Möglichkeit zu wählen.

Eine Steuereinheit 20 der Prozessoreinrichtung 100 dient zur Steuerung des von der Prozessoreinrichtung 100 durchzuführenden Abgleichs der Periodendauer T des Digitaloszillators auf eine Nominal-Periodendauer, welche durch den zwischen zwei zeilenperiodisch auftretenden Synchronisierimpulsen S1 und S2 verstreichenden Zeitraum festgelegt ist. Der Phasenabgleich wird durch den von der Impulstrennstufe 2 aus dem Luminanzsignal BAS separierten und über den ersten Eingang 100' der Prozessoreinrichtung 100 zur Steuereinheit 20 geleiteten Synchronisierimpuls S1 initiiert. Der Synchronisierimpuls S1 triggert die Steuereinheit 20, welche daraufhin den momentanen Wert des DCO-Ausgangssignals abspeichert. Dieser Wert repräsentiert die Ist-Phase des Digitaloszillators 10 zu diesem Triggerzeitpunkt. Diese Ist-Phase des DCO-Ausgangssignals wird zu einer Phasenkomparatoreinheit 30 geleitet und in dieser mit einem Phasenwort p verglichen, das die Soll-Phase des Digitaloszillators 10 für diesen Zeitpunkt repräsentiert. Die Phasenkomparatoreinheit 30 berechnet aus der Differenz der Ist-Phase und der Soll-Phase ein Phasendifferenzsignal, welches einer ersten Addierereinheit 40 zugeführt wird. An der Addiereinheit 40 liegt außerdem das Ausgangssignal des Mikroprozessors der Impulstrennstufe 2 an. Das eine zeitliche Genauigkeit von einem Takt aufweisende Phasendifferenzsignal wird mit dem auf Taktbruchteile genauen Ausgangssignal der Impulstrennstufe 2 in der ersten Addierereinheit 40 addiert. Das daraus resultierende Phasendifferenzsignal erreicht demgemäß eine zeitliche Auflösung der Phasenablage des Digitaloszillators 10, die auf Taktbruchteile genau ist.

Das derart modifizierte Phasendifferenzsignal wird an eine Schleifenfiltereinheit 50 geleitet. Dieses hat die Aufgabe, die dynamischen Eigenschaften der Phasenregelungsschleife in einer dem Fachmann bekannten Art und Weise zu beeinflussen. Das gefilterte Phasendifferenzsignal wird zu einer zweiten Addiereinheit 60 geführt, an der ein Frequenzwort f anliegt. Der Wert dieses Frequenzwortes f ist in Abhängigkeit von dem vorgegebenen Takt des Taktgenerators 13 und der Wortlänge N des Registerwortes des Akkumulator-Registers 11 derart bestimmt, daß der Digitaloszillator 10 bei einem sukzessiven taktweisen Akkumulieren des Registerwortes des Akkumulator-Registers 11 um das Frequenzwort f in der Nominal-Periodendauer überläuft.

In der zweiten Addiereinheit 60 wird das Steuerwort st des Digitaloszillators 10 durch die Addition des Frequenzwortes f und des gefilterten Phasendifferenzsignals gebildet. Der Wert des Steuerwortes st repräsentiert die Momentan-Periodendauer des Digitaloszillators 10. Das in der Prozessoreinrichtung 100 gebildete aktuelle Steuerwort st wird dann dem Eingang 10' des Digitaloszillators 10 zugeführt. In diesem wird dann das Registerwort des Akkumulator-Registers 11 während des durch die Zeile Z1 (vgl.Fig.2b) festgelegten Zeitraumes sukzessive im Takt des Taktgenerators 13 um das aktuelle Steuerwort erhöht, wodurch eine Annäherung der Frequenz bzw. der Periodendauer T des Digitaloszillators 10 an die durch die Synchronisierimpulse S1-S6 vorgegebene Nomimalfrequenz bzw. Nominal-Periodendauer erreicht wird.

Der nächste Phasenabgleich zwischen der Ist-Phase des Digitaloszillators 10 und der vorgegebenen Soll-Phase findet erst dann statt, wenn die digitale Phasenregelungsschleife 1 durch den am Beginn der Zeile Z2 auftretenden Synchronisierimpuls S2 getriggert wird. Dieser erneute Phasenabgleich erfolgt dann wie oben beschrieben. Analog dazu wird daran anschließend beim Auftreten des zeilenperiodischen Synchronisierimpulses S3 am Beginn der Zeile Z3 ein erneuter Phasenabgleich durchgeführt. Die digitale Phasenregelungsschleife 1 führt den Phasenabgleich also in einem ersten Regeltakt aus, der durch die zeilenperiodisch auftretenden Synchronisierimpulse S1,S2 und S3 vorgegeben ist. Ein derartiger Phasenabgleich führt dann dazu, daß die Periodendauer T des Digitaloszillators 10 schon nach einigen wenigen Zyklen des ersten Regeltaktes phasenstarr auf die Nominal-Periodendauer eingerastet ist.

Wie aus der Figur 2b zu ersehen ist, folgt dem zeilenperiodischen Synchronisierimpuls S3 ein nicht-zeilenperiodischer Synchronisierimpulse S4, der um 180°, d.h. um eine halbe Zeile versetzt auftritt. Dieser nicht-zeilenperiodische Synchronisierimpuls S4 führt bei den bekannten digitalen Phasenregelungsschleifen 1 dazu, daß die Rastung des Digitaloszillators 10 auf die Nominal-Periodendauer gestört wird, da bei diesen der Phasen-Abgleichvorgang durch alle an die digitale Phasenregelungsschleife gelangenden - also auch durch die nicht-zeilenperiodischen - Synchronisierimpulse ausgelöst wird.

Besonders wichtig ist deshalb, daß bei der erfindungsgemäßen digitalen Phasenregelungsschleife 1 nach deren Einrasten auf die Nominal-Periodendauer der Phasenabgleich zwischen Ist-Phase und Soll-Phase in einem zweiten Regeltakt durchgeführt wird, der es erlaubt, den nicht-zeilenperiodischen Synchronisierimpuls S4 derart in den Phasenregelungsvorgang mit einzubeziehen, daß die Rastung des Digitaloszillators 10 auf die Nominal-Periodendauer nicht gestört wird. Hierzu ist in besonders vorteilhafter Art und Weise vorgesehen, daß die Prozessoreinrichtung 100 aus dem DCO-Ausgangssignal eine Signalfolge der halben Zeilenperiodendauer erzeugt, deren Periodendauer TD exakt die Hälfte der Periodendauer T des DCO-Ausgangssignals beträgt. Diese Signalfolge der halben Zeilenperiodendauer wird dann zur Ermittlung der Phasendifferenz herangezogen. Es ist also vorgesehen, daß nach dem Einrasten der digitalen Phasenregelungsschleife 1 auf die durch die zeitliche Abfolge der zeilenperiodisch auftretenden Synchronisierimpulse S1-S3 vorgegebene Nominal-Periodendauer auf den durch die zeilenperiodischen Synchronisierimpulse S1-S3 und den nicht-zeilenperiodischen Synchronisierimpuls S4 vorgegebenen zweiten Regeltakt übergangen wird. In besonders vorteilhafter Art und Weise wird dabei die Signalfolge der halben Zeilenperiodendauer herangezogen, um durch einen Vergleich der Ist-Phase des Digitaloszillators 10 am Triggerzeitpunkt, also beim Auftreten eines der Synchronisierimpulse S1-S3 oder S4, mit der durch das Phasenwort p vorgegebenen Soll-Phase zu diesem Zeitpunkt die Phasenablage des Digitaloszillators festzustellen, d.h. das Phasendifferenzsignal zu berechnen. Der im zweiten Regeltakt durchgeführte Phasenabgleich gewährleistet nicht nur, daß der halbzeilige Versatz des nicht-zeilenperiodischen Synchronisierimpulses S4 gegenüber den zeilenperiodisch auftretenden Synchronisierimpulsen S1-S3 die digitale Phasenregelungsschleife 1 nicht stört. Diese Betriebsart zeichnet sich dadurch aus, daß der nicht-zeilenperiodische Synchronisierimpuls S4 von der Phasenmesschaltung des Digitaloszillators 10 erkannt wird. Ein weiterer Vorteil der digitalen Phasenregelungsschleife 1 besteht darin, daß der Phasenabgleich gegebenenfalls zweimal pro Zeile stattfinden kann. Dadurch wird ein besonders rasches Einschwingverhalten der digitalen Phasenregelungsschleife 1 erreicht. Die Phasendifferenz zwischen Ist-Phase und Soll-Phase wird linear über eine halbe Zeile - über 180° - gemessen, d.h. bei der gerasteten DPLL wird die Phasenmessung auf doppelter Zeilenfrequenz betrachtet. Da die Phasenablage des Digitaloszillators 10 mit einer halben Zeilenperiode ausgewertet wird, arbeitet die digitale Phasenregelungsschleife 1 in besonders vorteilhafter Art und Weise bei zwei verschiedenen Phasen (0 und 180° stabil.

Die Signalfolge 8 der halben Zeilenperiodendauer wird von der Steuereinheit 20 aus dem DCO-Ausgangssignal des Digitaloszillators 10 in besonders einfacher Art und Weise dadurch erzeugt, daß diese das als Vorzeichen dienende höchstwertige Bit N des DCO-Ausgangssignals nicht betrachtet. Die restlichen Bits N-1, N-2,...1 des DCO-Ausgangssignals bilden dann die Signalfolge der halben Zeilenperiodendauer. 5 Deren N-1 Bits werden als die VB-Darstellung einer Dezimalzahl betrachtet, woraus sich ergibt der in Figur 2a durch die Linie 8 dargestellte sägezahnförmige zeitliche Verlauf der Signalfolge der halben Zeilenperiodendauer ergibt. Wichtig ist, daß durch diese Art der Erzeugung der Signalfolge der halben Zeileperiodendauer deren starre Verkoppelung mit dem DCO-Ausgangssignal gegeben ist.

Das Bit N des DCO-Ausgangssignals wird als DPLL-Ausgangssignal zu einem Ausgang der digitalen Phasenregelungsschleife 1 geführt. Der zeitliche Verlauf des DPLL-Ausgangssignals wird durch die Linie 5 in Figur 2a dargestellt. Man erkennt, daß das DPLL-Ausgangssignal in diesem Fall den Signalverlauf eines zeilenfrequenten Rechtecksignals aufweist. Es ist aber auch möglich, ein DPLL-Ausgangssignal zu erzeugen, das eine höhere Präzision als das oben genannte, nur durch das Bit N des DCO-Ausgangssignals repräsentierte Signal aufweist. In diesem Fall ist dann vorgesehen, daß dem Ausgang der digitalen Phasenregelungsschleife 1 nicht nur das Bit N des DCO-Ausgangssignals, sondern - je nach der gewünschten Präzision - die Bits N-1, etc. zugeführt werden.

Zur Erzeugung eines mit dem zeitlichen Verlauf des Videosignals FBAS synchronisierten Adressphasensignals ist vorgesehen, daß das DCO-Ausgangssignal einer Korrektureinrichtung 110 zugeführt wird. Diese dient dazu, aus dem DCO-Ausgangssignal ein Adressphasen-Signal zu erzeugen, das auch dann zur Steuerung der zeilenfrequenten Operationen des Videosignal-Processings verwendet werden kann, wenn die zeitliche Abfolge der zeilenperiodischen Synchronisierimpulse S1-S3 und S5,S6 durch nicht-zeilenperiodisch auftretenden Synchronisierimpuls S4 unterbrochen oder um eine halbe Zeile verschoben wird.

Derartige zeilenfrequente Operationen ergeben sich bekanntlich aus der Verarbeitung des zeilenfrequenten FBAS-Signals: z.B. Messung der Synchronimpuls-Dachgleichspannung, Messung des Schwarzschulter-Gleichspannungspegels, Torschaltung für das Farbbezugssignal (=Burst-Impuls), Torschaltung für das eigentliche Videosignal, Torschaltung für den Synchronimpuls usw.. Jeder dieser Operationen, die durch ein entsprechendes "Key"-Signal Ki (= Ein-Bit-Steuersignal) aufgerufen oder ausgelöst werden, ist ein definierter Zeitpunkt ti bzw. ein Zeitfenster (= window) W1,W2 ... zugeordnet, dessen Auftreten bzw. Anfang und Ende durch Zeitmarken t1,t2,t3 ... festgelegt wird, wobei die Zeitmarken fest mit der Phase der jeweiligen Zeile verkoppelt sind. Diese Verkopplung wird mittels des Digitaloszillators 10 bewirkt, dessen N-stelliges Ausgangssignal in binärer Darstellung der jeweiligen Zeitmarke einer Zeile durch einen entsprechenden Zahlenwert definiert werden kann. Der Zeitmarke t1 entspricht somit der Zahlenwert N1, der Zeitmarke t2 der Zahlenwert N2 usw.

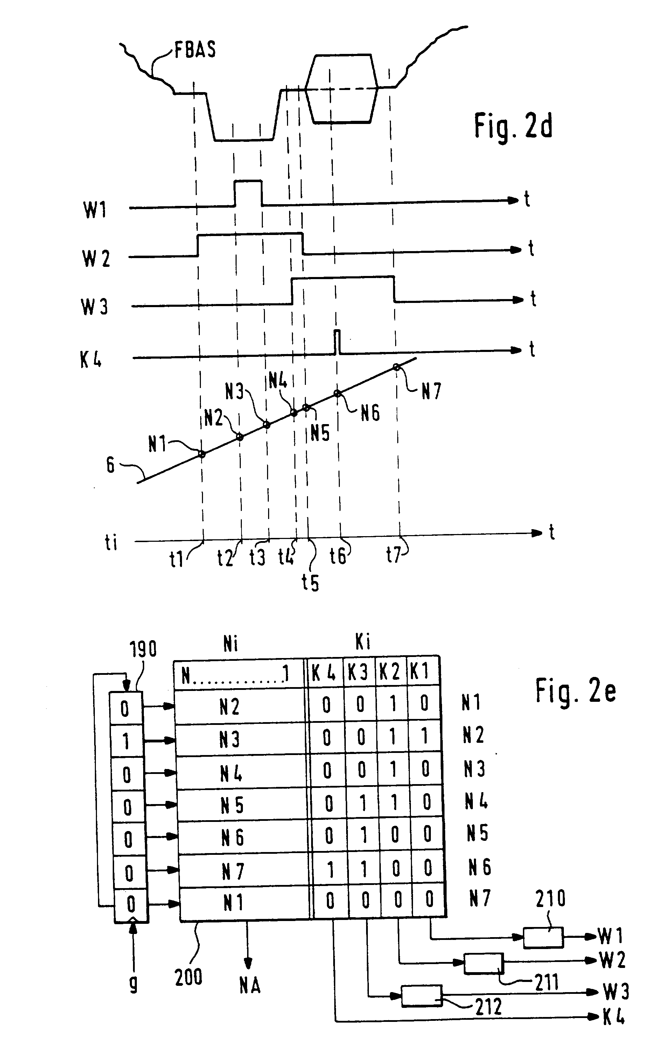

In Fig. 2d und Fig.2e ist die Funktionsweise der Key-Signalerzeugung Ki zur Verdeutlichung anhand eines einfachen Beispieles mit drei sich teilweise überlappenden Zeitfenstern W1,W2,W3 und einem einzelnen Key-Signal K4 schematisch dargestellt. Die erste Zeile zeigt den Signalverlauf eines Farbfernsehsignals FBAS im Bereich des Zeilenrücklaufintervalls. Die nächsten drei Zeilen zeigen jeweils die zeitliche Lage des ersten, zweiten und dritten Zeitfensters W1, W2,W3. Die fünfte Zeile zeigt die zeitliche Lage des nur eine Abtastperiode dauernden Key-Signals K4. Durch die darunter dargestellte schräge Linie 6 wird das zeilenperiodische DCO-Ausgangssignal dargestellt, vgl. auch Fig. 2c.

Jeder Zeitmarke t1 bis t7, die in Fig.2d als durchgehende gestrichelte Linien dargestellt sind, entspricht ein fester Zahlenwert N1 bis N7. Diese Zahlenwerte sind entsprechend der Fig.2e in einem adressierbaren Speicher 200 (vgl. auch Fig. 1) - der als ROM oder RAM (ROM = read only memory, RAM = random access memory) ausgebildet ist - in aufeinanderfolgend adressierbaren Speicherzellen abgelegt. Jede Speicherzelle enthält außer dem Zahlenwert Ni die jeweils gültigen Einträge der Key-Signale K1 bis K4. Der programmierte Zahlenwert Ni stellt das nächste Adresswort NA dar, bei dem die Kombination der Key-Signale K1 bis K4 zu ändern ist. Durch Vergleich des ausgelesenen nächsten Adressworts NA mit den A höchstwertigen Stellen des digitalen DCO-Ausgangssignals 6 in einem Komparator 180 wird ein Schiebetakt g für ein zyklisches Schieberegister 190 erzeugt, dessen umlaufende "1" als Zeiger für die aufeinanderfolgenden Speicheradressen des Speichers 200 dient, vgl. auch Fig. 1. Mittels der ausgelesenen Key-Einträge K1 bis K3 und jeweils einer Speicherschaltung 210, 211, 212 werden die drei Zeitfenster W1, W2, W3 erzeugt. Das einzelne Key-Signal K4 dient direkt als Steuersignal. Die drei Speicherschaltungen zur Bildung der drei Zeitfernstersignale sind erforderlich, weil die Key-Signale K1 bis K4 lediglich die Dauer einer einzigen Abtastperiode aufweisen.

Dem Komparator 180 wird das in der Korrektureinrichtung 110 aus dem DCO-Ausgangssignal des Digitaloszillators 10 erzeugte Adressphasensignal zugeleitet. Wie aus dem Vergleich des durch die Linie 4 dargestellten DCO-Ausgangssignals der Figur 2a und dem durch die Linie 6 repräsentierten Adressphasen-Signal der Figur 2c ersichtlich ist, ist letzteres mit dem DCO-Ausgangssignal während des durch die Zeile Z1 und Z2 gegebenen Zeitraumes identisch: Das DCO-Ausgangssignal und das Adressphasensignal weisen identische Phasenwerte auf, wodurch die Synchronität des Videosignal-Processings mit den zeitlichen Verlauf des Luminanzsignales BAS gewährleistet ist.

Bei einem nicht-zeilenperiodisch auftretenden Synchronisierimpulse S4 muß die Adressphase des Adressphasensignals korrigiert werden, um in diesem Fall die Synchronität der zeilenfrequenten Operationen des Videosignal-Processings mit dem Luminanzsignal BAS zu gewährleisten. Wie aus der Figur 2c ersichtlich ist, muß die Korrektureinrichtung 110 die Adressphase des Adressphasensignals um 180°, also um eine Periodendauer TD der Signalfolge der halben Zeilenperiodendauer verschieben.

Zur Durchführung dieser Korrektur weist die Korrektureinrichtung 110 zwei XOR-Gatter 150 und 160 auf. An einem ersten Eingang 150 des ersten XOR-Gatters 150 wird das höchstwertige Bit N des DCO-Ausgangssignals 10 angelegt. An einem zweiten Eingang 152 des ersten XOR-Gatters 150 liegt das das nächstniedrigere Bit N-1 des DCO-Ausgangssignals an. Ein Ausgang 153 des ersten XOR-Gatters 151 ist mit einem ersten Eingang 161 des zweiten XOR-Gatters 160 verbunden. An einem zweiten Eingang 162 des zweiten XOR-Gatters 160 liegt das höchstwertige Bit N des digitalen DCO-Ausganggsignals an.

Die Funktionsweise der durch die beiden XOR-Gatter aufgebauten Korrektureinrichtung 110 ist wie folgt: Wie aus Figur 2a ersichtlich ist, weisen bei einem nicht-zeilenperiodischen Synchronisierimpuls S4 das DCO-Ausgangssignal und die Signalfolge der halben Zeilenperiodendauer unterschiedliche Phasenwerte auf. Aufgrund der starren Verkopplung der Signalfolge der halben Zeilenperiodendauer mit dem DCO-Ausgangssignal beträgt diese Differenz zu diesem Zeitpunkt stets 180°. Dies bedeutet, daß bei einem nicht-zeilenperiodischen Synchronisierimpulse S4 das Bit N und das Bit N-1 des DCO-Ausgangssignals verschieden sind, da die Signalfolge der halben Zeilenperiodendauer durch die Bits N-1,N-2,...,1 des durch die Bits N,N-1,...,1 festgelegten DCO-Ausgangssignals erzeugt wird. In diesem Fall liegen aber an den beiden Eingängen des ersten XOR-Gatters 150 antivalente Binärsignale an. Am Ausgang 153 des ersten XOR-Gatters 150 tritt - der Verknüpfungslogik eines XOR-Gatters entsprechend, das logische Signal "1" auf. Im zweiten XOR-Gatter 160 erfolgt dann aufgrund der gegebenene antivalenten Belegung der Eingänge 161 und 162 eine Invertierung des am zweiten Eingang 162 anliegenden Bits N des DCO-Ausgangssignals. Das an einem Ausgang 163 auftretende Signal N' tritt nun an die Stelle des Bits N des DCO-Ausgangssignals. Das Adressphasensignal 6 setzt sich demgemäß aus dem Ausgangssignal des zweiten XOR-Gatters 160 an der höchstwertigen Stelle und aus den Bits N-1, N-2,...N-A des DCO-Ausgangssignals zusammen. Die Invertierung des Bits N des DCO-Ausgangssignals bewirkt eine Verschiebung der Adressphase des Adressphasen-Signals um 180°.

Die Korrektureinrichtung 110 ermöglicht es besonders einfach, einen nicht-zeilenperiodischen Synchronisierimpuls S4 durch die antivalente Belegung des Bits N und des Bits N-1 des DCO-Ausgangssignals zu detektieren und daraufhin eine Korrektur des Adressphasen-Signals durch die Invertierung des Bits N durchzuführen. Diese Maßnahmen besitzen den Vorteil, daß die Synchronität des Adressphasensignals zur Steuerung der zeilenfrequenten Operationen des Videosignal-Processings mit dem Luminanzsignals BAS stets gewährleistet ist, da das Adressphasensignal in einer genau festgelegten und eindeutigen Art und Weise mit dem DCO-Ausgangssignal korreliert ist, welches wiederum mit dem Luminanzsignal BAS synchronisiert ist.

## Patentansprüche

1. Digitale Phasenregelungsschleife (1) mit einem periodisch überlaufenden Digitaloszillator (10), der ein die Periodendauer T aufweisendes Digitaloszillator-Ausgangssignal erzeugt, indem ein Registerwort der Wortlänge N sukzessive im vorgegebenen Takt eines Taktgenerators (13) um ein an einem Eingang (10') des Digitaloszillators (10) anliegendes Steuerwort (st) erhöht wird, und mit einer Prozessoreinrichtung (100), welcher das die Ist-Phase des Digitaloszillators repräsentierende Digitaloszillator-Ausgangssignal zugeleitet wird, und die zum Abgleich der Periodendauer T des Digitaloszillators (10) auf eine durch periodisch auftretende Synchronisierimpulse (S1-S3,S5,S6) festgelegte Nominal-Periodendauer einen Phasenvergleich zwischen der Ist-Phase des Digitaloszillators (10) und einer vorgegebenen Soll-Phase durchführt, derart, daß die Prozessoreinrichtung (100) in einem durch die periodisch auftretenden Synchronisierimpulse (S1-S3,S5,S6) vorgegebenen ersten Regeltakt aus der momentanen Ist-Phase des Digitaloszillators (10) und aus der Soll-Phase ein Phasendifferenzsignal bildet, und daß das Phasendifferenzsignal in der Prozessoreinheit (100) gefiltert wird, und daß das gefilterte Phasendifferenzsignal mit einem Frequenzwort (f) addiert wird, das den Zahlenwert der Nominal-Periodendauer in Abhängigkeit von der Wortlänge N des Registerwortes des Digitaloszillators (10) und des vorgegebenen Taktes des Taktgenerators (13) derart repräsentiert, daß der Digitaloszillator (10) bei einem sukzessiven Akkumulieren des Registerwortes um das Frequenzwort (f) in der Nominal-Periodendauer überläuft, und daß das aus dem Frequenzwort (f) und dem Phasendifferenzsignal gebildete Steuerwort (st) dem Eingang (10') des Digitaloszillators (10) zugeführt wird, **dadurch gekennzeichnet**, daß die Prozessoreinrichtung (100) eine mit dem Digitaloszillator-Ausgangssignal verkoppelte Signalfolge der halben Zeilenperiodendauer erzeugt, deren Periodendauer TD gleich der halben Periodendauer T des Digitaloszillator-Ausgangssignals ist, und daß die Prozessoreinrichtung nach dem Einrasten des Digitaloszillators (10) auf die Nominal-Periodendauer den Phasenvergleich zwischen Ist-Phase und Soll-Phase in einem durch die zeilenperiodischen Synchronisierimpulse (S1-S3,S5,S6) und einen nicht-zeilenperiodischen Synchronisierimpuls (S4) vorgegebenen zweiten Regeltakt anhand der Signalfolge der halben Zeilenperiodendauer durchführt, und daß das Digitaloszillator-Ausgangssignal einer Korrektureinrichtung (110) zugeführt wird, die ein mit dem Digitaloszillator-Ausgangssignal verkoppeltes Adressphasensignal erzeugt, derart, daß die Adressphase des Adressphasensignals bei einem nicht-periodischen Synchronisierimpulses (S4) gegenüber der Phase des Digitaloszillator-Ausgangssignals um eine Periodendauer TD der Signalfolge der halben Zeilenperiodendauer verschoben wird.

2. Digitale Phasenregelungsschleife nach Anspruch 1, dadurch gekennzeichnet, daß der Digitaloszillator als Modulo-Addierer (10) aufgebaut ist, der einen das Registerwort speicherndes Akkumulator-Register (11) und einen Addierer (12) aufweist.

3. Digitale Phasenregelungsschleife nach Anspruch 1, dadurch gekennzeichnet, daß die Prozessoreinrichtung (100) eine Steuereinheit (20) aufweist, die durch einen an einem ersten Eingang (100') der Prozessoreinrichtung (100) anliegenden Synchronisierimpuls (S1-S6) getriggert wird und daraufhin den momentanen Wert des Digitaloszillator-Ausgangssignals als Ist-Phase des Digitaloszillators (10) abspeichert, und daß die Ist-Phase einer Phasenkomparatoreinheit (30) zugeführt ist, welche aus der Ist-Phase und einem die Soll-Phase des Digitaloszillators (10) zum Triggerzeitpunkt repräsentierenden Phasenwort (p) ein Phasendifferenzsignal bildet.

4. Digitale Phasenregelungsschleife nach Anspruch 3, dadurch gekennzeichnet, daß die Prozessoreinrichtung (100) eine erste Addiereinheit (40) enthält, die das in der Phasenkomparatoreinheit (30) gebildete Phasendifferenzsignal mit einem an einem zweiten Eingang (100") der Prozesseinrichtung (100) anliegenden, zur Feinregelung der digitalen Phasenregelungsschleife (1) dienenden Signal addiert.

5. Digitale Phasenregelungsschleife nach einem der Ansprüche 3 oder 4, dadurch gekennzeichnet, daß das Phasendifferenzsignal nach dem Filtern in einer Schleifenfiltereinheit (50) einer zweiten Addiereinheit (60) zugeführt wird, in der das Steuerwort (st) des Digitaloszillators (10) durch die Addition des gefilterten Phasendifferenzsignals und des Frequenzwortes (f) gebildet wird.

6. Digitale Phasenregelungsschleife nach einem der Ansprüche 1-5, dadurch gekennzeichnet, daß die in den einzelnen Funktionseinheiten (30,40,50,60) der Prozessoreinrichtung (100) auszuführenden Verarbeitungsoperationen des Digitaloszillator-Ausgangssignals durch einen programmgesteuerten Mikrocomputer ausgeführt werden.

7. Digitale Phasenregelungsschleife nach einem der Ansprüche 1-5, dadurch gekennzeichnet, daß die Funktionseinheiten (30,40,50,60) der Prozessoreinrichtung (100) als fest verdrahtete Logikschaltungen einer integrierten Schaltung realisiert sind.

8. Digitale Phasenregelungsschleife nach einem der Ansprüche 1-5, dadurch gekennzeichnet, daß die Funktionseinheiten (30,40,50,60) der Prozessoreinrichtung (100) als diskrete Bauelemente realsiert sind.

9. Digitale Phasenregelungsschleife nach Anspruch 1, dadurch gekennzeichnet, daß die Korrektureinrichtung (110) ein erstes XOR-Gatter (150) aufweist, an dessen ersten Eingang (151) das höchstwertige Bit N des Digitaloszillator-Ausgangssignals und an dessen zweiten Eingang (152) das nächstniedrigere Bit N-1 des Digitaloszillator-Ausgangssignals anliegt, und daß ein Ausgang (153) des ersten XOR-Gatters (150) mit einem ersten Eingang (161) eines zweiten XOR-Gatters (160) verbunden ist, und daß einem zweiten Eingang (162) des zweiten XOR-Gatters (160) das höchstwertige Bit N des Digitaloszillator-Ausgangssignals zugeführt ist.

10. Digitale Phasenregelungsschleife nach Anspruch 1 oder 9, dadurch gekennzeichnet, daß das in der Korrektureinrichtung (110) gebildete Adressphasensignal zu einem Komparator (180) geleitet wird, der die aktuelle Adressphase des Adressphasensignals mit einem gespeicherten Adresswort NA einer Speicheradresse eines Speichers (200) vergleicht, und daß der Komparator (180) ein zyklisches Schieberegister (190) ansteuert, dessen Schiebetakt (g) bei Übereinstimmung der aktuellen Adressphase des Adressphasensignals mit dem im Speicher (200) gespeicherten Adresswort NA einer Speicheradresse erzeugt wird.

11. Digitale Phasenregelungsschleife nach Anspruch 1, gekennzeichnet durch ihre Verwendung in einer Horizontalablenkeinrichtung eines Fernsehempfängers und der H-Synchronaufbereitung im Videorecorder, insbesondere bei Trick-Wiedergabe.

## Claims

1. Digital phase-locked loop (1) comprising a periodically overflowing digital oscillator (l0) which generates a digital oscillator output signal of period T representing the actual phase of the digital oscillator by increasing a register word of length N successively at a predetermined clock rate of a clock generator (13) by a control word (st) applied at an input (10') of the digital oscillator (10), and a processor device (l00) which is supplied with the digital oscillator output signal and which, to adjust the period T of the digital oscillator (10) to a nominal period determined by periodically occurring synchronizing pulses (S1-S3, S5, S6), performs a phase comparison between the actual phase of the digital oscillator (10) and a reference phase, such that the processor device (100) forms a phase-difference signal from the actual phase of the digital oscillator (10) and the reference phase at a first control clock rate determined by the periodically occurring synchronizing pulses (S1-S3, S5, S6), that the phase-difference signal is filtered in the processor device (100), that the filtered phase-difference signal is added to a frequency word (f) whose numberical value represents the nominal period as a function of the length N of the register word of the digital oscillator (10) and the predetermined clock rate of the clock generator (13) such that during successive accumulation of the register word by the frequency word (f), the digital oscillator (10) overflows in the nominal period, and that the control word (st) formed from the frequency word (f) and the phase-difference signal is applied to the input (10') of the digital oscillator (10),
**characterized in** that the processor device (100) generates a signal sequence of one-half line period which is locked to the digital oscillator output signal and whose period TD is equal to half the period T of the digital oscillator output signal, that after the digital oscillator (10) has locked to the nominal period, the processor device performs the phase comparison between actual phase and reference phase with the aid of the signal sequence of one-half line period and at a second control clock rate determined by the line-periodic synchronizing pulses (S1, ..., S5, S6) and a non-line-periodic synchronizing pulse (S4), and that the digital oscillator output signal is applied to a correction device (110) which generates an address-phase signal locked to the digital oscillator output signal, such that in the presence of a non-periodic synchronizing pulse (S4), the address phase of the address-phase signal is shifted by the period TD of the signal sequence of one-half line period with respect to the phase of the digital oscillator output signal.

2. A digital phase-locked loop as claimed in claim 1,
characterized in that the digital oscillator is designed as a modulo adder (10) containing an accumulator register (11) and an adder (12), said accumulator register (11) storing the register word.

3. A digital phase-locked loop as claimed in claim 1,
characterized in that the processor device (100) includes a control unit (20) which is triggered by a synchronizing pulse (S1-S6) applied to a first input (100') of the processor device (100) and then stores the instantaneous value of the digital oscillator output signal as the actual phase of the digital oscillator (10), and that the actual phase is applied to a phase comparator unit (30) which forms a phase-difference signal from the actual phase and a phase word (p) representing the reference phase of the digital oscillator (10) at the instant of triggering.

4. A digital phase-locked loop as claimed in claim 3,
characterized in that the processor device (100) includes a first adder unit (40) which adds the phase-difference signal formed in the phase comparator unit (30) to a signal applied to a second input (100") of the processor device (100) and serving to fine-control the digital phase-locked loop (1).

5. A digital phase-locked loop as claimed in claim 3 or 4, characterized in that the phase-difference signal, after being filtered in a loop filter unit (50),is applied to a second adder unit (60) in which the control word (st) of the digital oscillator (10) is formed by adding the filtered phase-difference signal and the frequency word (f).

6. A digital phase-locked loop as claimed in any one of claims 1 to 5, characterized in that the processing operations to be performed on the digital oscillator output signal in the individual functional units (30, 40, 50, 60) of the processor device (100) are performed by a program-controlled microcomputer.

7. A digital phase-locked loop as claimed in any one of claims 1 to 5, characterized in that the functional units (30, 40, 50, 60) of the processor device (100) are implemented as hard-wired logic of an integrated circuit.

8. A digital phase-locked loop as claimed in any one of claims 1 to 5, chacterized in that the functional units (30, 40, 50, 60) of the processor device (100) are implemented as discrete components.

9. A digital phase-locked loop as claimed in claim 1,
characterized in that the correction device (110) includes a first XOR gate (150) whose first input (151) is supplied with the most significant bit N of the digital oscillator output signal and whose second input (152) is supplied with the next less significant bit N-1 of the digital oscillator output signal, that an output (153) of the first XOR gate (150) is coupled to a first input (161) of a second XOR gate (160), and that a second input (162) of the second XOR gate (160) is supplied with the most significant bit N of the digital oscillator output signal.

10. A digital phase-locked loop as claimed in claim 1 or 9, characterized in that the address-phase output signal formed in the correction device (110) is fed to a comparator (180) which compares the current address phase of the address-phase signal with a stored address word NA of an address of a memory (200), and that the comparator (180) drives a cyclic shift register (190) whose shift clock (g) is generated when the current address phase of the address-phase signal agrees with the address word NA stored in the memory (200).

11. A digital phase-locked loop as claimed in claim 1,
characterized by being used in a horizontal deflection circuit of a television receiver and in a horizontal sync circuit of a video recorder, particularly for implementing special control features during playback.

## Revendications

1. Boucle numérique de régulation de phase (1) comportant un oscillateur numérique (10), qui est périodiquement le siège d'un dépassement de capacité et qui produit un signal de sortie de l'oscillateur numérique possédant une période de durée T, par le fait qu'un mot de registre de longueur N est accru successivement, à la cadence prédéterminée d'un générateur de cadence (13), d'un mot de commande (st) qui est appliqué à une entrée (10') de l'oscillateur numérique (10), et comportant un dispositif formant processeur (100), auquel est envoyé le signal de sortie de l'oscillateur numérique, qui représente la phase réelle de cet oscillateur, et qui, pour rendre la durée de période T de l'oscillateur numérique (10) égale à une durée de période nominale fixée par des impulsions de synchronisation (S1-S3,S5,S6) apparaissant de façon périodique, exécute une comparaison de phase entre la phase réelle de l'oscillateur numérique (10) et une phase de consigne prédéterminée, de telle sorte que le dispositif formant processeur (100) forme un signal de différence de phase à partir de la phase réelle instantanée de l'oscillateur numérique (10) et à partir de la phase de consigne, pendant un premier cycle de régulation, prédéterminé par les impulsions de synchronisation (S1-S3, S5,S6), qui apparaissent périodiquement, et que le signal de différence de phase est filtré dans une unité formant filtre de boucle du dispositif formant processeur (100) et qu'au signal de différence de phase filtré est additionné un mot de fréquence (f), qui représente la valeur chiffrée de la durée de période nominale en fonction de la longueur N du mot de registre de l'oscillateur numérique (10) et de la cadence prédéterminée du générateur de cadence (13), de sorte que lors d'une addition successive du mot de fréquence (f) au mot de registre, l'oscillateur numérique (10) est le siège d'un dépassement de capacité, pendant la durée de période nominale, et que le mot de commande (st) formé à partir du mot de fréquence (f) et du signal de différence de phase est envoyé à l'entrée (10') de l'oscillateur numérique (10), caractérisée en ce que le dispositif formant processeur (100) produit une suite de signaux qui est couplée au signal de sortie de l'oscillateur numérique et apparaît avec la moitié de la durée de la période de lignes et dont la durée de période TD est égale à la moitié de la durée de période T du signal de sortie de l'oscillateur numérique, et qu'après le verrouillage de l'oscillateur numérique (10) sur la durée de période nominale, le dispositif formant processeur exécute la comparaison de phase entre la phase réelle et la phase de consigne dans un second cycle de régulation, qui est prédéterminé par les impulsions de synchronisation (S1-S3,S5,S6) possédant la période de lignes et par une impulsion de synchronisation (S4) ne possédant pas la période de lignes, sur la base de la suite de signaux apparaissant avec la moitié de la durée de période de lignes, et que le signal de sortie de l'oscillateur numérique est envoyé à un dispositif de correction (110), qui produit un signal de phase d'adresse qui est accouplé au signal de sortie de l'oscillateur numérique de telle sorte que dans le cas d'une impulsion de synchronisation non périodique (S4), la phase d'adresse du signal de phase d'adresse est décalée, par rapport à la phase du signal de sortie de l'oscillateur numérique, d'une durée de période TD de la suite de signaux apparaissant avec la moitié de la durée de période de lignes.

2. Boucle numérique de régulation de phase selon la revendication 1, caractérisée en ce que l'oscillateur numérique est agencé sous la forme d'un additionneur modulo (10), qui comporte un registre accumulateur (11) mémorisant le mot de registre, et un additionneur (12).

3. Boucle numérique de régulation de phase selon la revendication 1, caractérisée en ce que le dispositif formant processeur (100) possède une unité de commande (20), qui est déclenchée par une impulsion de synchronisation (S1-S6) appliquée à une première entrée (100') du dispositif formant processeur (100) et mémorise alors la valeur instantanée du signal de sortie de l'oscillateur numérique en tant que phase réelle de l'oscillateur numérique (10), et en ce que la phase réelle est envoyée à une unité formant comparateur de phase (30), qui forme un signal de différence de phase à partir de la phase réelle et d'un mot de phase (p) représentant la phase de consigne de l'oscillateur numérique (10) à l'instant de déclenchement.

4. Boucle numérique de régulation de phase selon la revendication 3, caractérisée en ce que le dispositif formant processeur (100) contient un premier additionneur (40), qui additionne le signal de différence de phase formé dans l'unité formant comparateur de phase (30) et un signal appliqué à une seconde entrée (100") du dispositif formant processeur (100) et servant à réaliser le réglage précis de la boucle numérique de régulation de phase (1).

5. Boucle numérique de régulation de phase selon l'une des revendications 3 ou 4, caractérisée en ce que le signal de différence de phase est envoyé, après filtrage dans une unité formant filtre de boucle (50), à un second additionneur (60), dans lequel le mot de commande (st) de l'oscillateur numérique (10) est formé par addition du signal filtré de différence de phase du mot de fréquence (f).

6. Boucle numérique de régulation de phase selon l'une des revendications 1-5, caractérisée en ce que les opérations de traitement du signal de sortie de l'oscillateur de phase, qui doivent être exécutées dans les différentes unités fonctionnelles (30,40,50,60) du dispositif formant processeur (100), sont exécutées par un micro-ordinateur commandé par programme.

7. Boucle numérique de régulation de phase selon l'une des revendications 1-5, caractérisée en ce que les unités fonctionnelles (30,40,50,60) du dispositif formant processeur (100) sont réalisées sous la forme de circuits logiques, câblés de façon fixe, d'un circuit intégré.

8. Boucle numérique de régulation de phase selon l'une des revendications 1-5, caractérisée en ce que les unités fonctionnelles (30,40,50,60) du dispositif formant processeur (100) sont réalisées sous la forme de composants discrets.

9. Boucle numérique de régulation de phase selon la revendication 1, caractérisée en ce que le dispositif de correction (110) possède une première porte OU-EXCLUSIF (150), à la première entrée (151) duquel est appliqué le bit de valeur maximum N du signal de sortie de l'oscillateur numérique et à la seconde entrée (152) duquel est appliqué le bit de valeur immédiatement inférieur N-1 du signal de sortie de l'oscillateur numérique, et qu'une sortie (153) de la première porte OU-EXCLUSIF (150) est reliée à une première entrée (161) d'une seconde porte OU-EXCLUSIF (160), et que le bit de valeur maximum N du signal de sortie de l'oscillateur numérique est envoyé à une seconde entrée (162) de la seconde porte OU-EXCLUSIF (160).

10. Boucle numérique de régulation de phase selon la revendication 1 ou 9, caractérisée en ce que le signal de phase d'adresse, qui est formé dans le dispositif de correction (110), est envoyé à un comparateur (180), qui compare l'actuelle phase d'adresse du signal de phase d'adresse à un mot d'adresse mémorisé NA d'une adresse d'une mémoire (200), et que le comparateur (180) commande un registre à décalage cyclique (190), dont la cadence de décalage (g) est produite en cas de coïncidence de la phase d'adresse actuelle du signal de phase d'adresse avec le mot d'adresse NA, mémorisé dans la mémoire (200), d'une adresse de mémoire.

11. Boucle numérique de régulation de phase selon la revendication 1, caractérisée par son utilisation dans un dispositif de déviation horizontale d'un récepteur de télévision et pour la préparation de l'impulsion de synchronisation horizontale dans un enregistreur vidéo, notamment dans le cas de la reproduction d'un trucage.
